# EUROPÄISCHE PATENTSCHRIFT

(11) **EP 0 768 954 B1**
(45) Veröffentlichungstag und Bekanntmachung des Hinweises auf die Patenterteilung: **04.08.1999**
(21) Anmeldenummer: 96913448.5
(22) Anmeldetag: 02.05.1996
(51) Int. Cl.: B41B 19/00, G06K 15/02, G06K 15/12, G11B 7/125, G11B 7/135, G11B 7/16, G11B 7/26, G11B 11/12

(54) **VERFAHREN UND VORRICHTUNG ZUR BELICHTUNG**
EXPOSURE PROCESS AND DEVICE
PROCEDE ET DISPOSITIF D'EXPOSITION A LA LUMIERE

(30) Priorität: 04.05.1995 DE 19516057; 18.08.1995 DE 19530395
(43) Veröffentlichungstag der Anmeldung: 23.04.1997
(73) Patentinhaber: Heidelberger Druckmaschinen Aktiengesellschaft, 69115 Heidelberg (DE)
(72) Erfinder: FISCHER, Jörg-Achim, D-24107 Kiel (DE); LEISS, Klaus-Günter, D-24107 Kiel (DE)
(86) Internationale Anmeldenummer: DE9600755
(87) Internationale Veröffentlichungsnummer: WO9634745

(56) Entgegenhaltungen:
- EP-A- 0 243 659
- DE-A- 3 812 480
- US-A- 4 231 096
- US-A- 4 520 370
- PATENT ABSTRACTS OF JAPAN vol. 010, no. 288 (P-502), 30.September 1986 & JP 61 107317 A (MITA IND CO LTD), 26.Mai 1986,
- PATENT ABSTRACTS OF JAPAN vol. 018, no. 519 (P-1807), 29.September 1994 & JP 06 176409 A (RICOH CO LTD), 24.Juni 1994,

## Beschreibung

Die Erfindung bezieht sich auf das Gebiet der elektronischen Reproduktionstechnik und betrifft ein Verfahren zur punkt- und zeilenweisen Belichtung Von Aufzeichnungsmaterial mittels eines Lichtstrahls sowie eine elektronische Belichtungsvorrichtung, auch Belichter, Recorder oder Imagesetter genannt.

In einem Recorder wird ein durch ein Videosignal modulierter Lichtstrahl punkt- und zeilenweise über ein zu belichtendes Aufzeichnungsmaterial geführt. Das Aufzeichnungsmaterial ist dabei auf einer Halterung fixiert, die sich relativ zum Lichtstrahl bewegt. Im Falle eines Innentrommel-Gerätes ist das Aufzeichnungsmaterial auf einer stationären zylindersegmentförmigen Halterung oder Belichtungsmulde fixiert, und der Lichtstrahl wird mittels einer rotierenden Lichtstrahlablenk-Vorrichtung punkt- und zeilenweise über das Aufzeichnungsmaterial geführt. Der Recorder kann aber auch als Trommel-Gerät oder Flachbett-Gerät ausgebildet sein.

Als Lichtquelle zur Erzeugung des Lichtstrahles wird häufig ein Laser verwendet. Die vom Videosignal abhängige Modulation des Lichtstrahls erfolgt durch einen Modulator, beispielsweise durch einen akustooptischen Modulator. Die Ansteuerung des Modulators durch das Videosignal erfolgt bei der herkömmlichen Technik derart, daß der Modulator zeilenweise innerhalb von Belichtungszeiträumen, in denen der Lichtstrahl die zu belichtenden Zeilen auf dem Aufzeichnungsmaterial überstreicht, aktiviert und innerhalb von Rückführungszeiträumen, in denen der Lichtstrahl zu der nächsten zu belichtenden Zeile geführt wird, deaktiviert wird.

Bei einem herkömmlichen Recorder können in nachteiliger Weise Rückreflexionen (back reflections) von dem Modulator oder der Lichtstrahlablenk-Vorrichtung in Richtung auf die Lichtquelle auftreten, die verhindert werden müssen, um eine gute Aufzeichnungsqualität zu erzielen. Darüber hinaus wird ein hoher Wirkungsgrad des Modulators verlangt, damit für die Belichtung des Aufzeichnungsmaterials ein Lichtstrahl hoher Lichtleistung zur verfügung steht. Desweiteren müssen die verwendeten Bauelemente möglichst konstante Betriebseigenschaften haben, da sich beispielsweise durch Erwärmung der Bauelemente die optischen Eigenschaften des Lichtstrahles verändern können, was wiederum die Aufzeichnungsqualität mindert.

Aufgabe der vorliegenden Erfindung ist es daher, ein Verfahren und eine Vorrichtung zur Belichtung von Aufzeichnungsmaterial derart zu verbessern, daß bei Gewährleistung eines hohen Wirkungsgrades eine verbesserte Konstanz der Betriebseigenschaffen erreicht wird.

JP-A-61-107317 beschreibt hierzu, die Temperatur des Modulators mit einem Peltierelement zu kompensieren. JP-A-6-176409 beschreibt, einen Teil des Lichtstrahles aus der Lichtquelle ständig dem Modulator zuzuführen.

Diese Aufgabe wird bezüglich des Verfahrens durch die Merkmale des Anspruchs 1 gelöst.

Vorteilhafte Weiterbildungen und Ausgestaltungen sind in den Unteransprüchen angegeben.

Die Erfindung wird nachfolgend anhand der Fig. 1 bis 6 näher erläutert.

Es zeigen:
- Fig. 1: ein prinzipielles Blockschaltbild einer Belichtungs-Vorrichtung,
- Fig. 2: eine prinzipielle Darstellung einer Belichtungs-Vorrichtung vom Innentrommel-Typ im Schnittbild,
- Fig. 3: Zeitdiagramme zur Veranschaulichung der Signalverläufe bei ausgeschalteter Temperaturkompensation (Stand der Technik),
- Fig. 4: Zeitdiagramme zur Veranschaulichung der Signalverläufe bei eingeschalteter Temperaturkompensation gemäß der Erfindung,
- Fig. 5: Zeitdiagramme mit gegenüber der Fig. 4 veränderten Signalverläufen, bei denen die Dauer des Belichtungszeitraumes verkleinert wurde und
- Fig. 6: ein Ausführungsbeispiel für die Ansteuerschaltung in Form eines Blockschaltbildes.

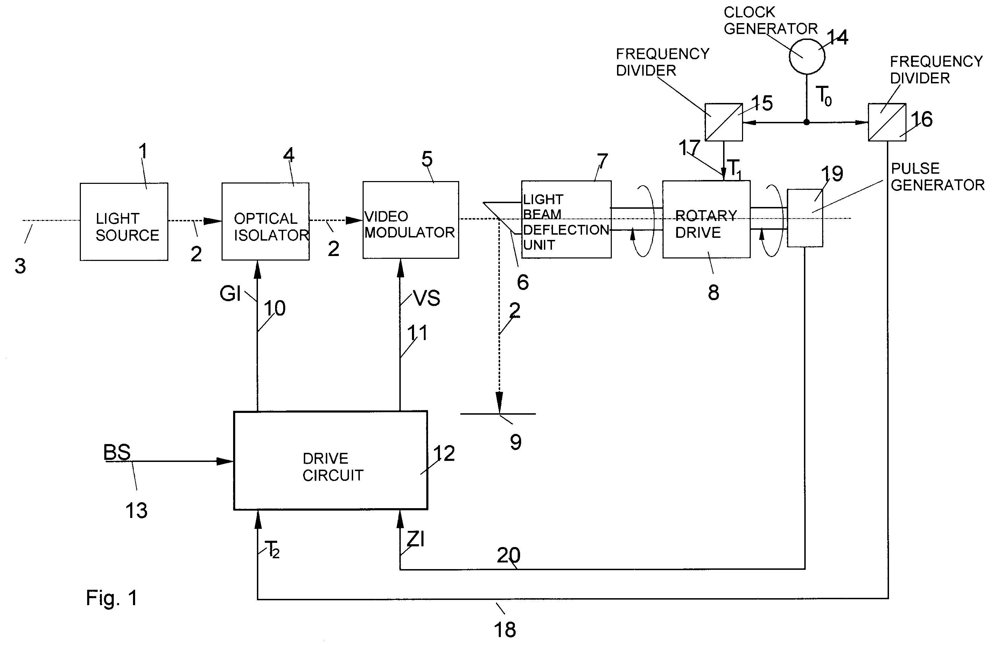

Fig. 1 zeigt den prinzipiellen Aufbau einer elektronischen Vorrichtung zum punkt- und zeilenweisen Belichten von Aufzeichnungsmaterial, nachfolgend mit Recorder bezeichnet. Eine Lichtquelle (1) erzeugt einen Lichtstrahl (2) entlang einer optischen Achse (3). Der Lichtstrahl (2) durchläuft einen steuerbaren optischen Isolator (4) und einen steuerbaren Videomodulator (5), die auf der optischen Achse (3) angeordnet sind. Im Bereich des optischen Isolators (4) beträgt ein typischer Durchmesser des Lichtstrahles (2) 1 mm, und im Bereich des Videomodulators (5) erfolgt eine Fokussierung auf einen Strahldurchmesser von beispielsweise 70 µm.

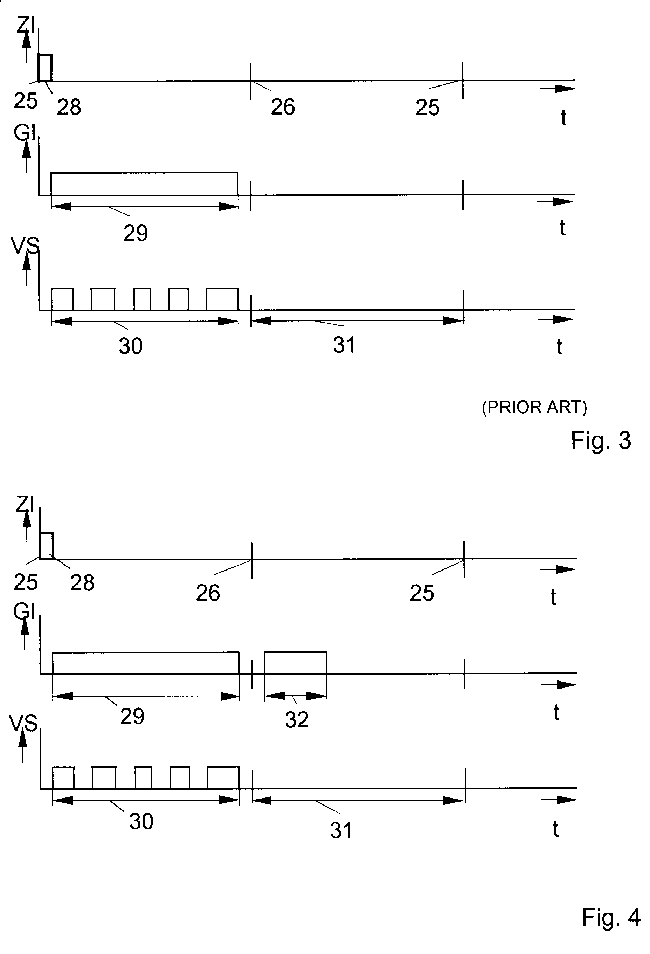

Der aus dem Videomodulator (5) austretende Lichtstrahl (2) fällt auf einen schräg zur optischen Achse (3) orientierten Spiegel (6) einer Lichtstrahl-Ablenkvorrichtung (7), die sich mittels eines Rotationsantriebes (8) um die optische Achse (3) dreht. Die Lichtstrahl-Ablenkvorrichtung (7) lenkt den am Spiegel (6) reflektierten Lichtstrahl (2) in einer senkrecht zur Zeichenebene verlaufenden Ablenkebene punkt- und zeilenweise über ein zu belichtendes Aufzeichnungsmaterial (9) ab. Das Aufzeichnungsmaterial (9) ist im Fall eines Flachbett-Gerätes auf einer ebenen Halterung und im Fall eines Innentrommel-Gerätes, wie in Fig. 2 näher dargestellt, an der Innenfläche einer stationären zylindersegmentförmigen Halterung oder Belichtungsmulde fixiert.

Als Lichtquelle (1) kann beispielsweise ein YAG-Laser verwendet werden. Der optische Isolator (4) ist als ein akustooptischer Modulator 1. Ordnung ausgebildet, der von Gate-Impulsen (GI) auf einer Leitung (10) ein- und ausgeschaltet wird. Der Videomodulator (5) ist ein akustooptischer Modulator 0. Ordnung, wodurch die Lichtmodulation des Lichtstrahls (2) mit einem hohen Wirkungsgrad und mit steilen Flanken durchgeführt werden kann. Der Videomodulator (5) wird von einem zweipegligen Videosignal (VS) auf einer Leitung (11) ein- und ausgeschaltet. Wirkungsweise und Aufbau von akustooptischen Modulatoren (AOM) sind bekannt.

Die Gate-Impulse (GI) und das Videosignal (VS) werden in einer Ansteuerschaltung (12) aus einem die aufzuzeichnenden Informationen tragenden Bildsignal (BS) erzeugt, das der Ansteuerschaltung (12) über eine Leitung (13) zugeführt wird.

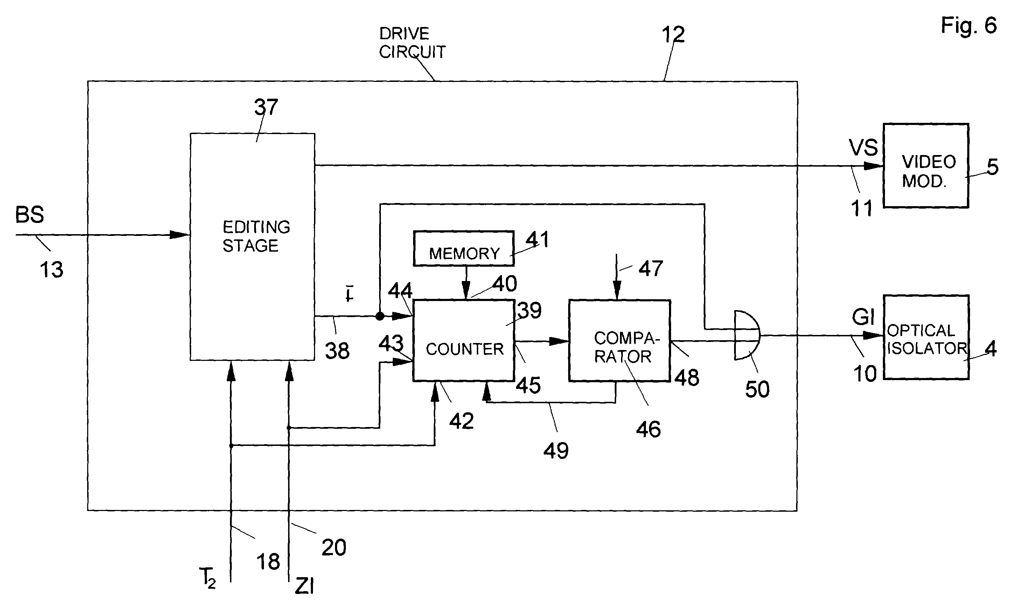

Zur Synchronisation der Ablenkbewegung des Lichtstrahles (2) mit der Signalerzeugung in der Ansteuerschaltung (12) erzeugt ein Taktgenerator (14) eine Grundtaktfolge T₀, aus der mittels von Frequenzteilern (15, 16) eine erste Referenztaktfolge T₁ und eine zweite Referenztaktfolge T₂ abgeleitet werden. Die erste Referenztaktfolge T₁ wird dem Rotationsantrieb (8) für die Lichtstrahl-Ablenkvorrichtung (7) über eine Leitung (17) zugeführt und dient als Referenzwert für eine Drehzahlregelung. Die zweite Referenztaktfolge T₂ gelangt über eine Leitung (18) an die Ansteuerschaltung (12) zur Koordinierung der Signalerzeugung. Ein Impulsgenerator (19), der in dem dargestellten Ausführungsbeispiel an den Rotationsantrieb (8) gekoppelt ist, erzeugt einmal pro Umdrehung der Lichtstrahl-Ablenkvorrichtung (7) einen Zeilenanfangs-Impuls (ZI). Die Zeilenanfangs-Impulse (ZI), auch "Start-Off-Line"-Impulse oder kurz SOL-Impulse genannt, bestimmen in jeder Zeile den Zeitpunkt, an dem der Gate-Impuls (GI) und das Videosignal (VS) für die Aufzeichnung freigegeben werden. Die Zeilenanfangs-Impulse (ZI) werden der Ansteuerschaltung (12) über eine Leitung (20) zugeführt. Ein Ausführungsbeispiel für die Ansteuerschaltung (12) ist in Fig. 6 angegeben.

Durch die Zwischenschaltung des optischen Isolators (4) zwischen Lichtquelle (1) und Videomodulator (5) werden in vorteilhafter Weise die in der Beschreibungseinleitung erwähnten störenden Rückreflexionen von dem Videomodulator (5) und der Lichtstrahl-Ablenkvorrichtung (7) auf die Lichtquelle (1) verhindert, indem der optische Isolator (4) die Wellenlängen des rückreflektierten Lichtes verstimmt. Dadurch ist sichergestellt, daß die Lichtquelle (1) stabil arbeitet. Da der als Modulator 0. Ordnung ausgebildete Videomodulator (5) zwar einen hohen Wirkungsgrad aufweist, aber den Lichtstrahl (2) nicht vollständig abschalten kann, besteht die Gefahr von störenden Fehlbelichtungen des Aufzeichnungsmaterials (9). Diese Fehlbelichtungen des Aufzeichnungsmaterials (9) werden in vorteilhafter Weise ebenfalls durch den optischen Isolator (4) unterbunden, indem dieser den Lichtstrahl (2) jeweils in den Belichtungspausen vollständig abschaltet.

Durch das Ein- und Ausschalten des optischen Isolators (4) durch die Gate-Impulse (GI) treten im optischen Isolator (4) thermische Effekte auf, welche die Betriebseigenschaften negativ beeinflussen. Beispielsweise kann sich aufgrund der Erwärmung des optischen Isolators (4) die Position des Lichtstrahls (2) verändern, was sich auf dem belichteten Aufzeichnungsmaterial (9) besonders dann störend bemerkbar macht, wenn der Recorder im sogenannten Start/Stop-Betrieb arbeitet. Ein Recorder muß immer dann im Start/Stop-Betrieb betrieben werden, wenn nicht sichergestellt ist, daß der zur Aufbereitung des Videosignals vorhandene Rechner, auch Raster-Image-Processor (RIP) genannt, das Videosignal zur Modulation des Lichtstrahls nicht kontinuierlich mit der erforderlichen Geschwindigkeit zur Verfügung stellen kann.

Durch eine Temperaturkompensation wird der optische Isolator (4) in vorteilhafter Weise thermisch stabilisiert, indem er durch die Art der Ansteuerung mittels der Gate-Impulse (GI) in den Belichtungszeiträumen und in den Rückführungszeiträumen für den Lichtstrahl (2) auf konstanter Temperatur gehalten wird.

Die erfindungsgemäße Temparaturkompensation wird nachfolgend näher erläutert.

Fig. 2 zeigt zunächst einen Recorder vom Innnentrommel-Typ im Schnittbild. Ein solcher Innentrommel-Recorder weist eine zylindersegmentförmige Halbschale oder Belichtungsmulde (22) mit einem Öffnungswinkel von beispielsweise 180° auf, in der das Aufzeichnungsmaterial (9) fixiert ist. Die Lichtstrahlablenk-Vorrichtung (7) rotiert um die Zylinderachse (23) der Belichtungsmulde (22) und führt den Lichtstrahl (2) in Richtung eines Pfeiles punkt- und zeilenweise über das Aufzeichnungsmaterial (9), wobei sich die Lichtstrahlablenk-Vorrichtung (7) in Richtung der Zylinderachse (23) bewegt.

Das Aufzeichnungsmaterial (9) erstreckt sich innerhalb der Belichtungsmulde (22) über einen Belichtungsbereich (24). Der Belichtungsbereich (24) kennzeichnet in jeder Belichtungsperiode (Zeile) den Belichtungszeitraum bzw. Modulationszeitraum, in dem der Lichtstrahl (2) die Belichtung einer Zeile auf dem Aufzeichnungsmaterial (9) vornimmt. Der Belichtungsbereich (24) beginnt hinter einer Anfangsmarkierung (25) bei dem Öffnungswinkel 0° und endet vor einer Endmarkierung (26) bei dem Öffnungswinkel 180°. Ein Rückführungsbereich (27), der bei der eingetragenen Pfeilrichtung an der Endmarkierung (26) beginnt und an der Anfangsmarkierung (25) endet, kennzeichnet den Rückführungszeitraum (Totzone), in dem keine Belichtung stattfindet und der Lichtstahl (2) jeweils zur nächsten Zeile geführt wird.

Fig. 3 zeigt Zeitdiagramme zur Veranschaulichung des zeitlichen Verlaufes der Steuersignale für den optischen Isolator (4) und den Videomodulator (5) nach dem Stand der Technik ohne die erfindungsgemäße Temperaturkompensation. Während des Belichtungsablaufes innerhalb einer Zeile wird bei der Anfangsmarkierung (25) für ein Zeitintervall (28) ein Zeilenanfangs-Impuls (ZI) erzeugt. Zeitlich versetzt zum Zeilenanfangs-Impuls (ZI) wird im Zeitintervall (29) ein Gate-Impuls (GI) an den optischen Isolator (4) gegeben, der diesen einschaltet, wobei die Dauer des Gate-Impulses (GI) der Länge einer Zeile beziehungsweise dem Belichtungsbereich (24) entspricht. Gleichzeitig wird das zweipeglige Videosignal (VS) im Belichtungszeitraum (30) für die betreffende Zeile dem Videomodulator (5) zugeführt, welches den Videomodulator (5) zur Belichtung der Zeile entsprechend dem jeweiligen Signalpegel ein- und ausschaltet.

Alle Signale liegen in demjenigen Zeitintervall, der zwischen der Anfangsmarkierung (25) und der Endmarkierung (26) liegt. Entsprechend dem jeweiligen Belichtungsablauf variieren die zeitlichen Längen der Gate-Impulse (GI) und des Belichtungszeitraumes (30) in Abhängigkeit von der jeweiligen Länge der Zeile bzw. des Belichtungsbereiches (24).

Ohne Temperaturkompensation wird der optische Isolator (4) innerhalb des Rückführungszeitraumes (31), der dem Rückführungsbereich (27) entspricht, nicht durch zusätzliche Gate-Impulse (GI) eingeschaltet, so daß die Betriebstemperatur des optischen Isolators (4) während des Rückführungszeitraumes (31) absinkt.

Fig. 4 zeigt Zeitdiagramme zur Veranschaulichung der Signalverläufe bei eingeschalteter Temperaturkompensation für den optischen Isolator (4) gemäß der Erfindung. Zusätzlich zu dem Gate-Impuls (GI) innerhalb des Zeitintervalls (29) ist innerhalb des Rückführungszeitraumes (31) ein Kompensationszeitraum (32) vorgesehen. Innerhalb des Kompensationszeitraumes (32) wird der optische Isolator (4) zusätzlich durch einen Gate-Impuls (GI) entsprechender Länge aktiviert, damit er sich im Rückführungszeitraum (31) erwärmt, um die Betriebstemperatur des optischen Isolators (4) in den einzelnen Belichtungsperioden, also jeweils in den Belichtungszeiträumen (30) und den Rückführungszeiträumen (31) insgesamt nahezu konstant zu halten.

Bei zeitlich veränderlicher Dauer des Belichtungszeitraumes (30) bzw. bei zeitlich veränderlicher Dauer des Gate-Impulses (GI) in jeder Zeile wird der Kompensationszeitraum (32) innerhalb des Rückführungszeitraumes (31) zwecks Temperaturkompensation in vorteilhafter Weise derart variiert, daß die Summe der zeitlichen Erstreckungen des Zeitintervalls (29) bzw. des Belichtungszeitraumes (30) und des Kompensationszeitraumes (32) in den Zeilen etwa konstant ist. Insbesondere wird angestrebt, eine exakte Konstanz zu erreichen. Zur ausreichenden Vermeidung von gegebenen Parameterabweichungen aufgrund von Temperaturunterschieden ist in der Praxis oft jedoch keine exakte Konstanz erforderlich.

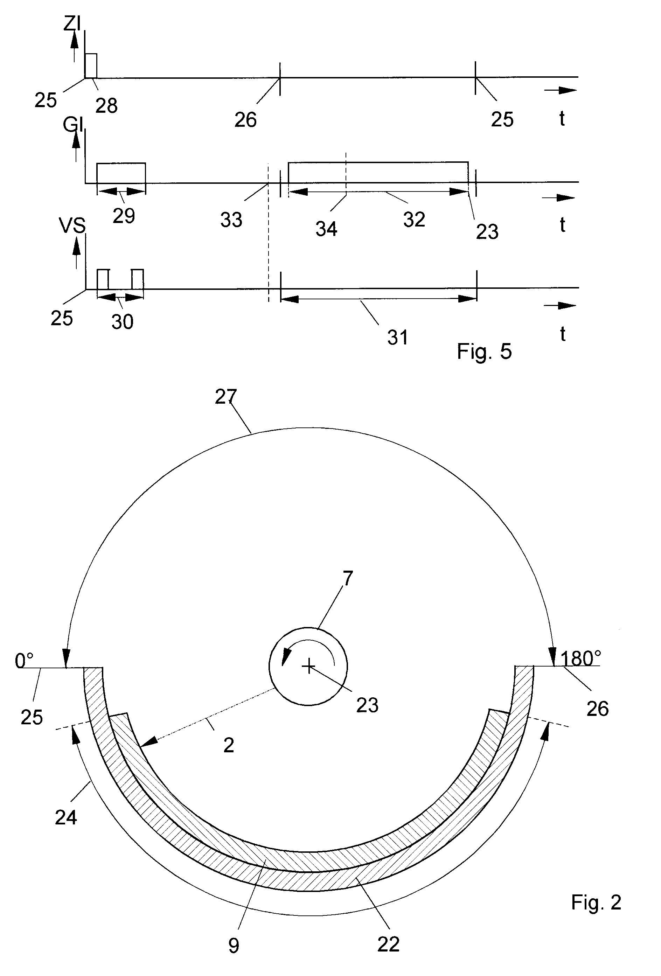

Fig. 5 zeigt Zeitdiagramme mit gegenüber der Fig. 4 veränderten Signalverläufen, bei denen die Dauer des Zeitintervalls (29) für den Gate-Impuls (GI) und des Belichtungszeitraumes (30) verkleinert, die Dauer des Kompensationszeitraumes (32) hingegen verlängert ist.

Dies führt dazu, daß das Ende des Belichtungszeitraumes (30) auf der Zeitachse "t" weiter nach links und das Ende des Kompensationszeitraumes (32) weiter nach rechts wandert. Um einen Vergleich mit der Fig. 4 zu ermöglichen, sind in Fig. 5 zusätzlich das Ende des Belichtungszeitraumes (30) nach Fig. 4 als gestrichelte Linie (33) und das Ende des Kompensationszeitraumes (32) nach Fig. 4 als gestrichelte Linie (34) eingetragen.

In Fig. 5 wurde nun relativ zu Fig. 4 der Kompensationszeitraum (32) um die zeitliche Differenz zwischen dem Ende des Kompensationszeitraumes (32) und der gestrichelten Linie (34) verlängert. Dieser Zeitraum entspricht der zeitlichen Differenz zwischen der gestrichelten Linie (33) und dem Ende des Belichtungszeitraumes (30). Die Summe der zeitlichen Erstreckungen von Belichtungszeitraum (30) und Kompensationszeitraum (32) ist hierdurch in bevorzugter Weise konstant geblieben.

Durch diese Konstanz der Aktivierungszeiträume des optischen Isolators (4) wird für eine konstante Erwärmung des optischen Isolators (4) gesorgt. Hierdurch werden in vorteilhafter Weise Positionsänderungen des Lichtstrahls (2) durch Temperaturschwankungen vermieden. Durch die Konstanthaltung der Erwärmung des optischen Isolators (4) werden außerdem störende Dichteänderungen auf dem Aufzeichnungsmaterial (9) beim Start-Stop-Betrieb der Belichtungs-Vorrichtung vermieden, so daß insgesamt eine hohe Aufzeichnungsqualität erreicht wird.

Fig. 6 zeigt ein Ausführungsbeispiel für die Ansteuerschaltung (12) in Form eines Blockschaltbildes. Das Bildsignal (BS) auf der Leitung (13) wird einer Aufbereitungs-Stufe (37) zugeführt, die außerdem mit der zweiten Referenztaktfolge T₂ auf der Leitung (18) und den Zeilenanfangs-Impulsen (ZI) auf der Leitung (20) beaufschlagt ist. In der Aufbereitungs-Stufe (37) werden aus dem Bildsignal (BS) das Videosignal (VS) auf der Leitung (11) und die Gate-Impulse (GI) für das Zeitintervall (29) bzw. den Belichtungszeitraum (30) auf einer Leitung (38) abgeleitet. Das Videosignal (VS) wird dem Videomodulator (5) zugeführt.

Ein Zähler (39) ist über einen Ladeeingang (40) mit einer Voreinstellung aufladbar, die in einem Speicher (41) bevorratet ist und gegebenenfalls zur Anpassung an jeweilige Anwendungsanforderungen verändert werden kann. Der Zähler (39) weist darüber hinaus einen Takteingang (42), einen Starteingang (43) sowie einen Zähleingang (44) auf. An den Starteingang (43) werden die Zeilenanfangs-Impulse (ZI) auf der Leitung (20) angelegt, um einen Ladevorgang des Zählers (39) mit dem im Speicher (41) bevorrateten Voreinstellungswert zu veranlassen. Am Zähleingang (44) liegen die Gate-Impulse (GI) auf der Leitung (38) an.

Während der zeitlichen Dauer der Gate-Impulse (GI) zählt der Zähler (39) von seinem Voreinstellungswert im Takt der am Takteingang (42) anliegenden Referenztaktfolge T₂ seinen Zählerstand herunter. Der aktuelle Zählerwert ist an einem Zählerausgang (45) verfügbar und wird an einen Komparator (46) übergeben. Der Kom-parator (46) weist einen Steuereingang (47), einen Signalausgang (48) sowie eine Zählerrückkopplung (49) auf.

Am Steuereingang (47) liegt ein Signal an, das den Komparator (46) darüber informiert, ob die Lichtstrahlablenk-Vorrichtung (7) bereits auf den Rückführungsbereich (27) ausgerichtet ist. Ist dies der Fall, vergleicht der Komparator (46), ob am Zählerausgang (45) des Zählers (39) der Wert "Null" anliegt. Ist dies nicht der Fall, so aktiviert der Komparator (46) die zusätzlichen Gate-Impulse (GI) für die Kompensationszeiträume (32). Gleichzeitig wird über die Zählerrückkopplung (49) der Zähler (39) dazu veranlaßt, seinen Zählerstand weiter zu vermindern. Der Kompensationszeitraum (32) erstreckt sich hierdurch solange, bis der Zähler (39) auf "Null" zurückgezählt hat. Die in der Aufbereitungs-Stufe (37) erzeugten Gate-Impulse (GI) für die Belichtungszeiträume (30) auf der Leitung (38) und die am Signalausgang (48) des Komparators (46) erzeugten zusätzlichen Gate-Impulse (GI) für die Kompensationszeiträume (32) werden in einem ODER-Glied (50) miteinander verknüpft und dem optischen Isolator (4) über die Leitung (10) zugeführt.

Über eine gegebenenfalls erfolgende Voreinstellung des Komparators (46) kann vorgegeben werden, daß der Kompensationszeitraum (32) nicht unmittelbar im Anschluß an die Endmarkierung (26) beginnt, sondern daß eine vorgebbare Distanz realisiert ist.

Die exakte zeitliche Positionierung der Gate-Impulse (GI) wird durch die erforderliche Belichtungslänge innerhalb der Zeilen und durch die Anfangsposition der Zeilen bestimmt. Gegebenenfalls kann das Zeitintervall (29) gegenüber dem Belichtungszeitraum (30) etwas früher beginnen und etwas später enden, um durch einen Vorlauf und einen Nachlauf Trägheitseffekte des optischen Isolators (4) auszugleichen und um zu gewährleisten, daß zumindest während des Belichtungszeitraumes (30) Rückreflektionen mittels des optischen Isolators (4) vermieden werden.

Es liegt im Rahmen der Erfindung, die Temperaturkompensation nicht nur, wie beschrieben, beim optischen Isolator (4), sondern generell bei jedem Modulator durchzuführen, der jeweils in Belichtungszeiträumen aktiviert und in anschließenden Rückführungszeiträumen für den Lichtstrahl deaktiviert ist. In diesem Fall werden anhand des Videosignals jeweils in einem Belichtungszeitraum die Einschaltintervalle des Modulators festgestellt und der Modulator in dem anschließenden Rückführungszeitraum für einen Kompensationszeitraum eingeschaltet, der der Summe der festgestellten Einschaltintervalle des Modulators entspricht.

## Patentansprüche

1. Verfahren zur Belichtung von Aufzeichnungsmaterial, bei dem
- in einer Lichtquelle (1) ein Lichtstrahl (2) erzeugt wird,
- der Lichtstrahl (2) in einem Modulator (4, 5) moduliert wird und
- das Aufzeichnungsmaterial (9) durch den modulierten Lichtstrahl (2) punkt- und zeilenweise belichtet wird, wobei der Modulator (4, 5) in den einzelnen Belichtungsperioden in einem Belichtungszeitraum (30), in dem die jeweilige Zeile belichtet wird, aktiviert und innerhalb eines Rückführungszeitraumes (31) für den Lichtstrahl (2) mindestens zeitweise deaktiviert wird und wobei der Belichtungszeitraum (30) mindestens innerhalb einiger unterschiedlicher Belichtungsperioden unterschiedliche zeitliche Erstreckungen aufweist **dadurch gekennzeichnet,** daß zur Kompensation von Parameterschwankungen aufgrund von unterschiedlichen Betriebstemperaturen des Modulators (4, 5)
- innerhalb des Rückführungszeitraumes (31) während eines Kompensationszeitraumes (32) eine Aktivierung des Modulators (4, 5) durchgeführt wird, in dem sich der Modulator (4, 5) erwärmt und
- innerhalb jeder Belichtungsperiode die Summe der zeitlichen Erstreckungen des Belichtungszeitraumes (30) und des Kompensationszeitraumes (32) etwa konstant ist.

2. Verfahren nach Anspruch 1, **dadurch gekennzeichnet**, daß als Lichtquelle (1) ein Laser verwendet wird.

3. Verfahren nach Anspruch 1 oder 2, **dadurch gekennzeichnet**, daß
- zwischen Lichtquelle (1) und Modulator (5) im Strahlengang des Lichtstrahles (2) ein weiterer Modulator (4) angeordnet wird,
- der zwischengeschaltete Modulator (4) als steuerbarer optischer Isolator verwendet wird und
- der Modulator (5) als Videomodulator betrieben wird, der von einem die aufzuzeichnende Information tragenden Videosignal (VS) gesteuert wird.

4. Verfahren nach einem der Ansprüche 1 bis 3, **dadurch gekennzeichnet**, daß die Modulatoren (4, 5) als akusto-optische Modulatoren ausgebildet sind.

5. Verfahren nach Anspruch 4, **dadurch gekennzeichnet**, daß der zwischengeschaltete Modulator (4) als akusto-optischer Modulator 1. Ordnung betrieben wird.

6. Verfahren nach Anspruch 4 oder 5, **dadurch gekennzeichnet**, daß der Videomodulator (5) als akusto-optischer Modulator 0. Ordnung betrieben wird.

7. Verfahren nach einem der Ansprüche 3 bis 6, **dadurch gekennzeichnet**, daß der zwischengeschaltete Modulator (4) den auf das Aufzeichnungsmaterial (9) gerichteten Lichtstrahl (2) in den Belichtungspausen vollständig abschaltet.

8. Verfahren nach einem der Ansprüche 1 bis 7**, dadurch gekennzeichnet,** daß die zeitliche Dauer des Kompensationszeitraumes (32) durch einen Zähler (39) vorgegeben wird, der ausgehend von einem Anfangsladewert während des Belichtungszeitraumes (30) heruntergezählt wird und der nach einem Start des Kompensationszeitraumes (32) bis auf einen vorgebbaren Endwert weiter herunter gezählt wird und bei dem durch Erreichen des vorgegebenen Endwertes das Kompensationsende des Kompensationszeitraumes (32) gesteuert wird.

## Claims

1. A method for the exposure of recording material, in which
- a light beam (2) is generated in a light source (1),
- the light beam (2) is modulated in a modulator (4, 5) and
- the recording material (9) is exposed by the modulated light beam (2) by point and by line, the modulator (4, 5) being activated in the individual exposure periods in an exposure interval (30) in which the respective line is exposed, activated and deactivated at least temporarily within a return interval (31) for the light beam (2) and the exposure interval (30) having different chronological extents at least within a few different exposure periods, characterised in that for the compensation of parameter fluctuations owing to different operating temperatures of the modulator (4, 5)
- within the return interval (31) during a compensation interval (32) an activation of the modulator (4, 5) is carried out, in which the modulator (4, 5) heats up and
- within each exposure period the sum of the chronological extents of the exposure interval (30) and of the compensation interval (32) is approximately constant.

2. The method according to Claim 1, characterised in that as light source (1) a laser is used.

3. The method according to Claim 1 or 2, characterised in that
- between the light source (1) and modulator (5) in the path of rays of
- the light beam (2) a further modulator (4) is arranged,
- the intercalated modulator (4) is used as a controllable optical isolator
and
- the modulator (5) is operated as a video modulator, which is controlled by a video signal (VS) carrying the information which is to be recorded.

4. The method according to any one of Claims 1 to 3, characterised in that the modulators (4, 5) are constructed as acousto-optical modulators.

5. The method according to Claim 4, characterised in that the intercalated modulator (4) is operated as acousto-optical modulator of the first degree.

6. The method according to Claim 4 or 5, characterised in that the video modulator (5) is operated as acousto-optical modulator of the degree 0.

7. The method according to any one of Claims 3 to 6, characterised in that in the exposure pauses the intercalated modulator (4) completely switches off the light beam (2) directed onto the recording material (9).

8. The method according to any one of Claims 1 to 7, characterised in that the chronological duration of the compensation interval (32) is given by a counter (39), which starting from an initial load value is counted down during the exposure interval (30) and which after a start of the compensation interval (32) is further counted down to a specifiable end value and in which by reaching the given end value the compensation end of the compensation interval (32) is controlled.

## Revendications

1. Procédé d'exposition d'un support d'enregistrement selon lequel
- on génère un faisceau lumineux (2) avec une source lumineuse (1),
- on module le faisceau lumineux (2) dans un modulateur (4, 5) et
- on expose le support d'enregistrement (9) point par point et ligne par ligne, par le faisceau lumineux modulé (2), le modulateur (4, 5) étant activé, dans les différentes périodes d'exposition, dans un intervalle de temps d'exposition (30) dans lequel la ligne respective est exposée, et à l'intérieur d'un intervalle de retour (31) du faisceau lumineux (2), on le désactive au moins périodiquement, et l'intervalle de temps d'exposition (30) présente des durées différentes à l'intérieur d'au moins certaines périodes d'exposition différentes,
caractérisé en ce que
pour compenser les variations des paramètres liées à des températures de fonctionnement différentes du modulateur (4, 5),
- à l'intérieur de l'intervalle de temps de retour (31), pendant un intervalle de temps de compensation (32), on active le modulateur (4, 5) en faisant chauffer ce modulateur (4, 5),
- à l'intérieur de chaque période d'exposition la somme des durées de l'intervalle de temps d'exposition (30) et de l'intervalle de temps de compensation (32), est sensiblement constante.

2. Procédé selon la revendication 1,
caractérisé en ce que
la source lumineuse (1) est un laser.

3. Procédé selon la revendication 1 ou 2,
caractérisé par
un autre modulateur (4) prévu entre la source lumineuse (1) et le modulateur (5) dans le chemin du faisceau lumineux (2),
- le modulateur (4) interposé est un isolateur optique commandé, et
- le modulateur (5) fonctionne comme un modulateur vidéo commandé par un signal vidéo (VS) portant l'information à enregistrer.

4. Procédé selon l'une des revendications 1 à 3,
caractérisé en ce que
les modulateurs (4, 5) sont des modulateurs acousto-optiques.

5. Procédé selon la revendication 4,
caractérisé en ce que
le modulateur interposé (4) est un modulateur acousto-optique du premier ordre.

6. Procédé selon les revendications 4 ou 5,
caractérisé en ce que
le modulateur vidéo (5) est un modulateur acousto-optique d'ordre O.

7. Procédé selon l'une des revendications 3 à 6,
caractérisé en ce que
le modulateur (4) interposé coupe complètement le faisceau lumineux (2) dirigé sur le support d'enregistrement (9) pendant les pauses d'exposition.

8. Procédé selon l'une quelconque des revendications 1 à 7,
caractérisé en ce qu'
on prédétermine la durée de l'intervalle de temps de compensation (32) par un compteur (39) qui, partant d'une valeur initiale chargée, est décompté pendant l'espace de temps d'exposition (30) et qui, après un démarrage de l'intervalle de temps de compensation (32), est décompté jusqu'à une valeur finale prédéterminée et lorsqu'on atteint la valeur finale prédéterminée, on commande la fin de la compensation de l'intervalle de temps de compensation (32).
